# EUROPÄISCHE PATENTSCHRIFT

(11) **EP 0 809 304 B1**
(45) Veröffentlichungstag und Bekanntmachung des Hinweises auf die Patenterteilung: **13.04.2005**
(21) Anmeldenummer: 97107577.5
(22) Anmeldetag: 07.05.1997
(51) Int. Cl.: H01L 33/00, H01L 31/0203, H01L 31/0232

(54) **Optoelektronischer Wandler und dessen Herstellungsverfahren**
Optoelectronic converter and process of manufacturing
Convertisseur optoélectronique et procédé de fabrication

(30) Priorität: 24.05.1996 DE 19621124
(43) Veröffentlichungstag der Anmeldung: 26.11.1997
(73) Patentinhaber: Infineon Technologies AG, 81669 München (DE)
(72) Erfinder: Gramann, Wolfgang, Dipl. Ing, 93053 Regensburg (DE); Bogner, Georg, Dipl. Ing, 93138 Hainsacker (DE); Weigert, Martin, Ing., 93152 Hardt (DE); Dietrich, Ralf, 81539 München (DE)
(74) Vertreter: Müller, Wolfram Hubertus, Dipl.-Phys.

(56) Entgegenhaltungen:
- WO-A-82/02800
- JP-A- 5 102 531
- US-A- 2 918 584
- US-A- 4 663 652
- US-A- 5 298 768
- US-A- 5 331 512
- YASUDA Y: "Infrared high-power LEDs expected to evolve to new applications" JEE JOURNAL OF ELECTRONIC ENGINEERING, Bd. 26, Nr. 270, Seite 52-54 XP000036208 ISSN: 0385-4507

## Beschreibung

Die Erfindung bezieht sich auf einen optoelektronischen Wandler mit einem Strahlung aussendenden und/oder empfangenden Körper, der auf einer Trägereinheit befestigt ist. Sie bezieht sich insbesondere auf einen derartigen optoelektronischen Wandler, bei dem der Strahlung aussendende und/oder empfangende Körper ein entsprechend ausgebildeter Halbleiterchip oder eine Polymer-Lumineszenz- oder -Laserdiode ist .

Ein derartiger optoelektronischer Wandler ist beispielsweise aus der europäischen Patentschrift EP 4 12 184 B1 bekannt und in Figur 12 dargestellt. Bei diesem bekannten optoelektronischer Wandler handelt es sich um eine Strahlungsdetektoranordnung, die ein Detektorbauelement 39, beispielsweise eine Fotodiode, einen gemeinsamen Träger 33, einen Isolierkörper 34, ein Befestigungsteil 35, einen Linsenträger 36 und eine Linse 37 zur Fokussierung der von dem Detektorbauelement 39 empfangenen Strahlung. Das Detektorbauelement 39 ist mit seiner Unterseite auf dem Isolierkörper 34 befestigt, der wiederum auf den gemeinsamen Träger 33 befestigt ist. Das Befestigungsteil 35 ist neben dem Isolierkörper 34 auf dem gemeinsamen Träger 33 angeordnet. Auf dem Befestigungsteil 35 ist mittels einer Befestigungsschicht 38 der Linsenträger 36 mit der Linse 37 fixiert, derart, daß sich die Linse 37 über der Strahleneintrittsfläche 40 des Detektorbauelements 39 befindet.

Die Montage der einzelnen Bestandteile eines derartigen optoelektronischen Wandlers ist sehr aufwendig. Sie erfordert eine große Zahl von Verfahrensschritten und die Justage der Linse 37 ist sehr schwierig. Außerdem treten im allgemeinen aufgrund des Luftspaltes zwischen der Linse 37 und dem Detektorbauelement 39 große Reflexionsverluste bzw. Abbildungsfehler innerhalb des Wandlers auf.

Weiterhin ist aus der deutschen Offenlegungschrift DE 43 23 681 ein optoelektronischer Wandler bekannt, bei dem auf der einen Seite eines lichtdurchlässigen Trägers ein optisches Empfangs- oder Sendeelement und auf der anderen Seite des Trägers eine Ablenkspiegelanordnung und eine parallel zur Trägerlängsachse verlaufende Lichtleitfaser angeordnet sind. Das beispielsweise von einem optischen Sendeelement aüsgesandte Licht durchdringt den gemeinsamen Träger, wird an der Ablenkspiegelanordnung um 90° in Richtung der Lichtleitfaser abgelenkt und in diese eingekoppelt. Im Falle eines Empfangselements wird das durch die Lichtleitfaser ankommende Lichtsignal an der Ablenkspiegelanordnung um 90° in Richtung Empfangselement abgelenkt, durchdringt anschließend den gemeinsamen Träger und wird in das Empfangselement eingekoppelt.

Auch die Herstellung dieser bereits bekannten Anordnung erfordert einen hohen Montage- und Justieraufwand. Herkömmliche Methoden zur Montage von Halbleiterbauelementen auf einer Leiterplatte können bei dieser Anordnung nicht verwendet werden.

Darüber hinaus ist ein optoelektronischer Wandler mit den Merkmalen gemäß dem Oberbegriff des Anspruchs 1 bekannt. Dieser vorbekannte Wandler weist eine Ausnehmung in einer Trägerplatte auf, in der ein Strahlung aussendender Körper befestigt ist (vgl. JP 05102531).

Der Erfindung liegt daher die Aufgabe zugrunde, einen optoelektronischen Wandler der eingangs genannten Art zu entwikkeln, der mit herkömmlichen Methoden der Bauelementmontage montierbar, insbesondnere zur Oberflächenmontage geeignet ist, das heißt in SMD-Technik (Surface mounted device) auf einer Leiterplatte befestigt werden kann.

Gleichzeitig soll dieser optoelektronische Wandler auf einfache Weise in großen Stückzahlen herstellbar und gegenüber weiteren optischen Einrichtungen ohne großen Aufwand exakt justierbar sein sowie eine hohe Effizienz bei der Lichtauskopplung aufweisen.

Diese Aufgabe wird durch einen optoelektronischen Wandler mit den Merkmalen des Anspruches 1 gelöst.

Vorteilhafte Weiterbildungen der Erfindung sind Gegenstand der Unteransprüche 2 bis 9. Bevorzugte Verfahren zum Herstellen einer Mehrzahl von erfindungsgemäßen optoelektronischen Wandlern sind Gegenstand des Anspruchs 10.

Der erfindungsgemäße optoelektronische Wandler hat gegenüber den eingangs beschriebenen bekannten optoelektronischen Wandlern den Vorteil, daß er auf einfache Weise auf einer Leiterplatte (z. B. Platine, Keramiksubstrat oder Hybridsubstrat) befestigt werden kann, indem er mit seinen Anschlußflächen auf Leiterbahnen der Leiterplatte gesetzt und die Anschlußflächen mittels eines elektrisch leitenden Bindemittels mit den Leiterbahnen verbunden werden. Der Wandler ist somit derart beispielsweise auf einer Leiterplatte montierbar, daß der Körper zwischen dem Trägerteil und der Leiterplatte angeordnet ist.

Bei dem erfindungsgemäßen optoelektronischen Wandler ist der Strahlung aussendende und/oder empfangende Körper derart auf der Trägereinheit montiert, daß seine Strahlungsaustrittsfläche zur Montagefläche hin gerichtet ist. Die Trägereinheit besteht hierbei aus einem zumindest für einen Teil der von dem Körper ausgesandten und/oder empfangenen Strahlung durchlässigen Material.

Dies hat den besonderern Vorteil, daß die von dem Körper ausgesandte und/oder empfangene Strahlung ohne große Reflexionsverluste und Verluste durch Abbildungsfehler in eine Lichtleitfaser oder in eine andere optische Anordnung bzw. in den Körper eingekoppelt werden kann.

Außerdem ist bei dem erfindungsgemäßen optoelektronischen Wandler vorgesehen, daß die Trägereinheit eine Trägerplatte mit einer Ausnehmung aufweist, daß auf einer Bodenfläche der Ausnehmung die Montagefläche vorgesehen ist und daß zumindest Teilbereiche von Seitenwänden der Ausnehmung als Anschlußteile genutzt sind.

Der Vorteil dieses Merkmals besteht insbesondere darin, daß auf einfache Weise eine Mehrzahl von erfindungsgemäßen optoelektronischen Wandlern im Scheibenverbund gleichzeitig hergestellt werden können. Eine separate genaue Positionierung und Montage der Anschlußteile auf der Trägerplatte ist nicht notwendig.

Bei einer vorteilhaften Weiterbildung der Erfindung besteht die Trägerplatte aus einem isolierenden Material oder ist die Trägerplatte gegebenenfalls in der Ausnehmung sowie auf den Anschlußteilen zumindest teilweise mit einer isolierenden Schicht versehen. In der Ausnehmung sowie auf den Anschlußteilen ist eine Anzahl von mit den elektrischen Kontakten des Strahlung aussendenden und/oder empfangenden Körpers verbindbaren, elektrisch leitenden Anschlußbahnen vorgesehen, die derart strukturiert sind, daß auf den Anschlußteilen eine Anzahl von Anschlußflächen, die zur Oberflächenmontage des Bauelements geeignet sind, ausgebildet ist. Dies hat insbesondere den Vorteil, daß die elektrisch leitenden Anschlußbahnen auf einfache Weise mittels herkömmlicher Methoden der Halbleitertechnik (Maskentechnik + Aufdampfen oder Sputtern von Metallschichten usw.) hergestellt werden können.

Bei einer besonders bevorzugten Ausführungsform des erfindungsgemäßen optoelektronischen Wandlers weist die Trägereinheit ein Mittel zum Fokussieren der Strahlung auf, wodurch vorteilhafterweise die ausgesandte bzw. empfangene Strahlung ohne große Verluste durch Totalreflexion an Grenzflächen aus dem Wandler ausgekoppelt bzw. in diesen eingkoppelt werden können.

Bei einer anderen vorteilhaften Weiterbildung der Erfindung sowie deren Ausführungsformen besteht die Trägerplatte aus einem elektrisch isolierenden Material oder ist zumindest teilweise mit einer isolierenden Schicht versehen und sind auf der Trägerplatte bzw. auf der isolierenden Schicht mindestens zwei strukturierte Metallisierungsschichten aufgebracht, auf denen elektrisch leitende Anschlußteile angeordnet sind.

Dies hat den besonderen Vorteil, daß die Abmessungen und die Positionen der elektrisch leitenden Anschlußteile auf einfache Weise den Abmessungen des auf der Montagefläche befindlichen Strahlung aussendenden und/oder empfangenden Körpers gegebenenfalls einschließlich der Anschlußleiter und/oder Abdeckmittel für den Körper angepaßt werden können.

Bei einer weiteren bevorzugten Ausführungsform des erfindungsgemäßen optoelektronischen Wandlers ist auf der dem Körper gegenüberliegenden Seite der Trägerplatte eine weitere Platte vorgesehen.

Dadurch ist es möglich, die Trägereinheit aus Materialien mit unterschiedlichen Brechungsindizes herzustellen und dadurch die Aufbauhöhe und die optische Abbildung des optoelektronischen Wandlers zu optimieren. Außerdem kann vorteilhafterweise die weitere Platte ein Mittel zum Fokussieren der Strahlung aufweisen.

Bei einer besonders bevorzugten Ausführungsform des erfindungsgemäßen optoelektronischen Wandlers ist zumindest der Strahlung aussendende und/oder empfangende Körper mit einer Kunststoffabdeckung oder einer andersartigen Abdeckung versehen. Dadurch ist auf einfache Weise der Körper gegen Feuchtigkeit und gegen mechanische Beschädigung geschützt.

Weitere Merkmale, Vorteile und Zweckmäßigkeiten der Erfindung ergeben sich aus der nachfolgenden Beschreibung von Ausführungsbeispielen in Verbindung mit den Figuren 1, 2 und 6 bis 11.

Es zeigen:
Figur 1 eine schematische Schnittdarstellung durch ein erstes Ausführungsbeispiel eines erfindungsgemäßen optoelektronischen Wandlers mit einer Ausnehmung in einer Trägerplatte;
Figur 2 eine schematische Darstellung einer Draufsicht auf den optoelektronischen Wandler von Figur 1;
Figur 3 zum besseren Verständnis und zum Vergleich eine schematische Schnittdarstellung durch ein optoelektronischen Wandler ohne Ausnehmung in der Trägerplatte;
Figur 4 eine schematische Darstellung einer Draufsicht auf den optoelektronischen Wandler von Figur 3;
Figur 5 zum besseren Verständnis und zum Vergleich eine schematische Schnittdarstellung durch einen weiteren optoelektronischen Wandler ohne Ausnehmung in der Trägerplatte;
Figur 6 eine schematische Schnittdarstellung eines zweiten Ausführungsbeispieles eines erfindungsgemäßen optoelektronischen Wandlers;
Figur 7 eine schematische Darstellung einer Draufsicht auf den optoelektronischen Wandler von Figur 6;
Figur 8 eine schematische Schnittdarstellung eines dritten Ausführungsbeispieles eines erfindungsgemäßen optoelektronischen Wandlers;
Figur 9 eine schematische Darstellung zur Erläuterung eines Verfahrensablaufes zur Herstellung einer Mehrzahl von erfindungsgemäßen optoelektronischen Wandlern gemäß Figur 8 und
Figuren 10 und 11 schematische Darstellungen zur Erläuterung eines Verfahrens zur Herstellung einer Mehrzahl von erfindungsgemäßen optoelektronischen Wandlern gemäß Figur 6.

In den Figuren sind gleichartige Komponenten der verschiedenen Ausführungsbeispiele jeweils mit denselben Bezugszeichen versehen.

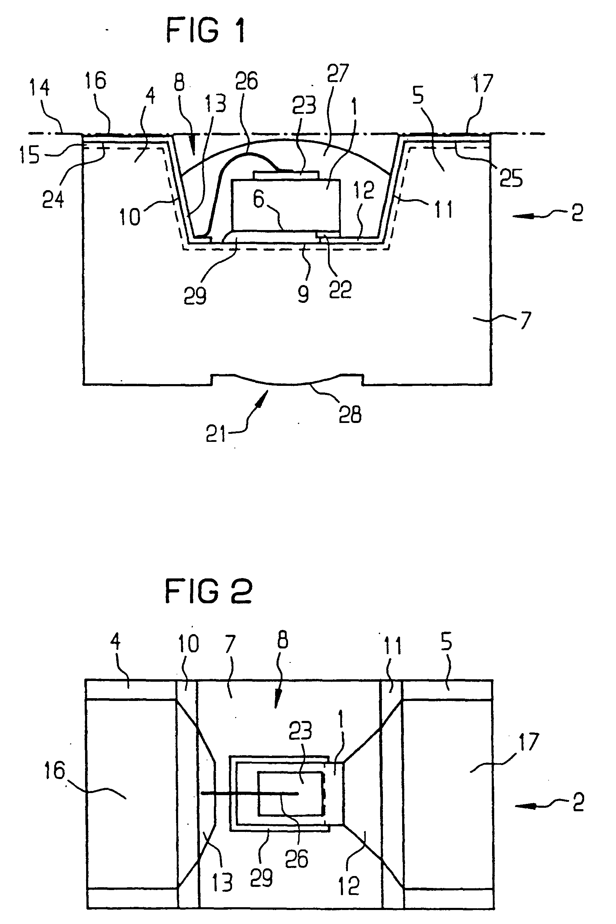

Bei dem optoelelektronischen Wandler von Figur 1 und 2 weist die Trägereinheit 2 eine Trägerplatte 7 mit einer trapezförmigen Ausnehmung 8 auf. Auf der Bodenfläche 9 und den Seitenflächen 10,11 der Ausnehmung 8 sowie auf den Oberseiten 24, 25 der Anschlußteile 4,5 sind zwei voneinander getrennte elektrisch leitende Anschlußbahnen 12,13 beispielsweise in Form von Metallisierungsschichten aufgebracht. Auf den Anschlußteilen 4,5 sind dadurch zwei Anschlußflächen 16,17 des optoelektronischen Wandlers ausgebildet.

Auf der Bodenfläche (9) der Ausnehmung 8 ist ein Strahlung aussendender und/oder empfangender Körper 1 derart befestigt, daß dessen Unterseitenkontakt 22 zumindest teilweise auf der elektrisch leitenden Anschlußbahn 12 aufliegt und mit dieser beispielsweise mittels eines AuSn-Lotes oder mittels eines anderen geeigneten elektrisch leitenden Bindemittels verbunden ist. Ein Oberseitenkontakt 23 des Körpers 1 ist mittels eines Anschlußleiters 26 (z. B. ein Bonddraht) mit der elektrisch leitenden Anschlußbahn 13 verbunden.

Der Körper 1 ist beispielsweise eine Leuchtdiode, eine Fotodiode (PIN-Fotodoide) oder ein Vertical Cavity Surface Emitting Laser (VCSEL).

Die Trägerplatte 7 ist elektrisch isolierend und besteht beispielsweise aus einem für die von dem Körper 1 ausgesandte bzw. empfangene Strahlung durchlässigen Glas, Kunststoff, Saphir, Diamant oder Halbleitermaterial. Für Wellenlängen λ > 400 nm kann beispielsweise SiC, für λ > 550 nm GaP, für λ > 900 nm GaAs und für λ > 1100 nm kann Silizium verwendet werden. Die Ausnehmung 8 ist beispielsweise mittels Ätzen, Sägen oder Fräsen hergestellt. Ebenso kann eine elektrisch leitfähige Trägerplatte 7 verwendet sein, die dann aber in der Ausnehmung und auf den Anschlußteilen 4,5 zumindest teilweise mit einer isolierenden Schicht 15 (z. B. eine Oxidschicht oder Kunststoffschicht usw.) versehen ist.

Die elektrisch leitenden Anschlußbahnen 12, 13 bestehen beispielsweise aus Aluminium, aus einer Aluminium-Basislegierung oder aus einem Au-Mehrschichtsystem. Denkbar ist auch, daß im Falle der Verwendung einer Trägerplatte 7 aus einem Halbleitermaterial in der Ausnehmung 8 sowie auf den Oberseiten 24, 25 der Anschlußteile 4, 5 mittels geeigneter Dotierung die Anschlußbahnen ausgebildet sind. Zur Herstellung einer derartigen Dotierung können die dem durchschnittlichen Fachmann heute bekannten Verfahren der Halbleitertechnik, wie beispielsweise Ionenimplantation, verwendet werden.

Zwischen der Strahlungsaustritts- und/oder -eintrittsfläche 6 des Körpers 1 und der Trägerplatte 7 befindet sich zur Verbesserung der Lichtauskopplung aus dem Körper 1 bzw. aus der Trägerplatte 7 ein optisches Koppelmedium 29, beispielsweise ein Gießharz. Die Verbesserung der Lichtauskopplung beruht auf einer Erhöhung des Winkels, bei dem Totalreflexion auftritt. Als wesentliche Eigenschaft weist das Koppelmedium 29 nur eine geringe Absorption der von dem Halbbleiterchip 1 ausgesandten und/oder empfangenen Strahlung auf.

Der Vollständigkeit halber sei an dieser Stelle erwähnt, daß die Strahlungsaustritts- und/oder -eintrittsfläche 6 des Strahlung aussendenden Körpers 1 diejenige Fläche ist, durch welche der größte Anteil der im Körper 1 erzeugten Strahlung aus diesem austritt. Analog dazu ist die Strahlungseintrittsfläche eines Strahlung empfangenden Körpers 1 diejenige Fläche, durch welche eine empfangene Strahlung in den Körper 1 eintritt.

Die Anschlußflächen 16,17 definieren eine Kontaktierungsebene (durch die strichpunktierte Linie 14 angedeutet), deren Abstand zur Bodenfläche 9 größer ist als die maximale Höhe des Körpers 1 einschließlich Anschlußleiter 26 und einer wahlweise vorgesehenen Chipabdeckung 27, die beispielsweise aus einem mit Quarzkügelchen oder -flocken gefüllten Harz oder aus einem Acrylat besteht. Die Chipabdeckung 27 dient insbesondere dazu, den Körper 1 vor Feuchtigkeit und vor mechanischer Beschädigung zu schützen.

Auf ihrer der Ausnehmung 8 gegenüberliegenden Seite weist die Trägerplatte 7 ein Mittel 21 zum Fokussieren der von dem Körper 1 ausgesandten und/oder empfangenen Strahlung auf, z. B. eine sphärische Linse, eine aspärische Linse oder eine Beugungsoptik. Dieses kann beispielsweise mittels Ätzen oder Schleifen in der Trägerplatte 7 ausgebildet oder separat hergestellt und beispielsweise mittels Löten, Kleben oder anodischem Bonden auf der Trägerplatte 7 aufgebracht sein.

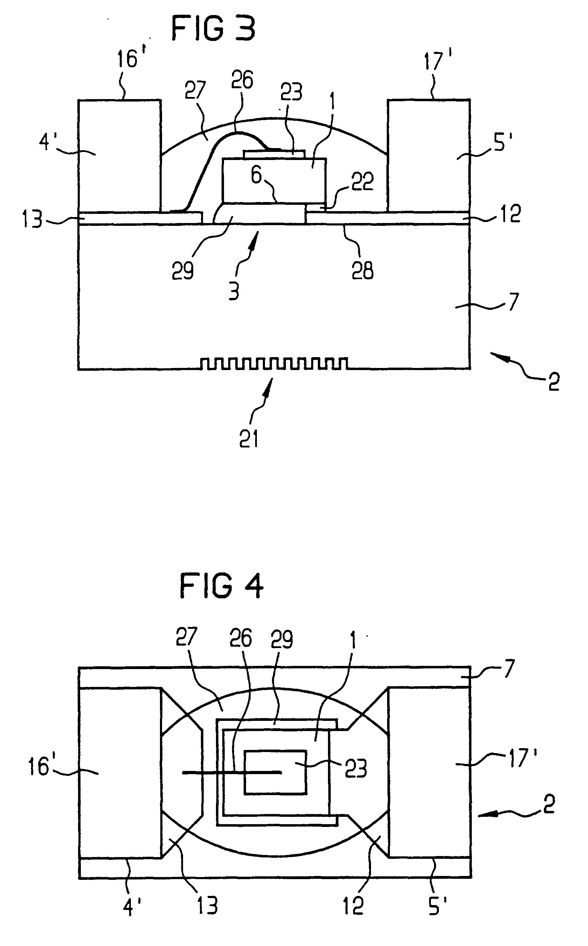

Bei dem in den Figuren 3 und 4 dargestellten optoelektronischen Wandler, der nicht Teil der Erfindung ist, weist die Trägerplatte 7 eine ebene Oberseite 28 auf, auf der die elektrisch leitenden Anschlußbahnen 12, 13 aufgebracht sind. Die Trägerplatte 7 kann aus einem elektrisch isolierenden Material gefertigt sein (z. B. Material wie bei dem obigen Ausführungsbeispiel von Figur 1 und 2) oder elektrisch leitend sein, wobei sie dann zumindest teilweise mit einer elektrisch isolierenden Schicht (z. B. Oxidschicht oder Kunststoffschicht usw.) versehen ist.

Wie beim Ausführungsbeispiel gemäß den Figuren 1 und 2 ist auch hier der Körper 1 derart auf einer Montagefläche 3 der Trägerplatte 7 befestigt, daß er zumindest mit einem Teil seines Unterseitenkontaktes 22 auf der elektrisch leitenden Anschlußbahn 12 aufliegt und mit dieser elektrisch leitend verbunden ist. Auf den elektrisch leitenden Anschlußbahnen 12,13 sind beispielsweise mittels Löten oder Kleben Anschlußteile 4',5' befestigt, die elektrisch leitend sind, so daß die Oberseiten 24, 25 der Anschlußteile 4',5' die elektrischen Anschlußflächen 16',17' des optoelektronischen Wandlers ausbilden.

Die Anschlußteile 4',5' bestehen beispielsweise aus hochleitendem Silizium, Metall oder aus einem anderen Material mit hoher elektrischer Leitfähigkeit. Als Bindemittel zwischen den Anschlußteilen 4',5' und den elektrisch leitenden Anschlußbahnen 12,13 ist beispielsweise ein metallisches Lot oder ein elektrisch leitender Kunststoff verwendet. Ebenso können die Anschlußteile 4',5' mittels eutektischem Bonden auf den Anschlußbahnen 12,13 befestigt werden.

Als Materialien für die Trägerplatte 7 und die elektrisch leitenden Anschlußbahnen 12, 13 eignen sich beispielsweise die in Bezug auf das erstgenannte Ausführungsbeispiel entsprechend angegebenen Materialien.

Die Trägerplatte 7 weist auch hier auf ihrer dem Körper 1 gegenüberliegenden Seite ein Mittel 21 zum Fokussieren der von dem Körper ausgesandten und/oder empfangenen Strahlung auf. Repräsentativ hierfür ist in Figur 3 eine Beugungsoptik eingezeichnet.

Darüberhinaus kann auch bei diesem Ausführungsbeispiel der Körper 1 mittels einer Chipabdeckung 27 gegen Feuchtigkeit und gegen mechanische Beschädigung geschützt sein (Materialien für die Chipabdeckung 27 wie oben zu Figur 1 angegeben).

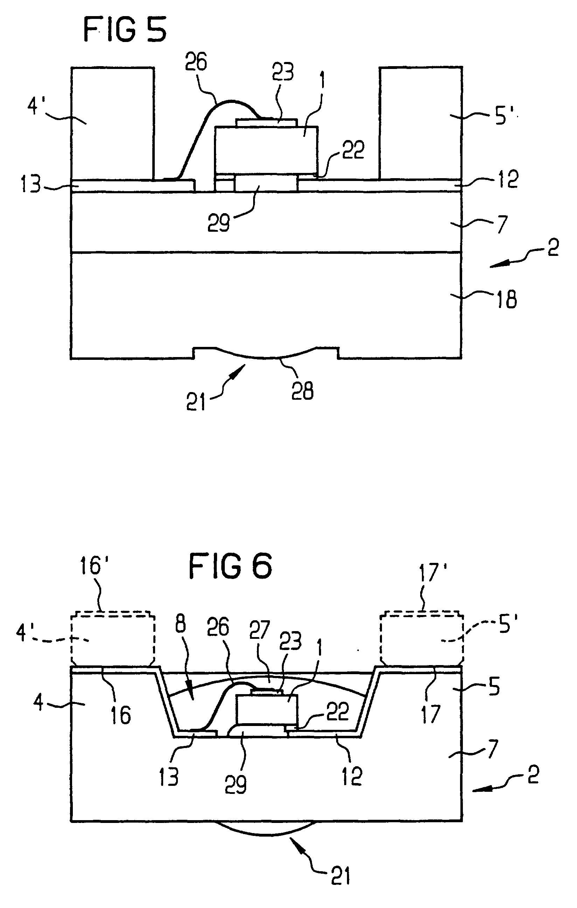

Das Ausführungsbeispiel von Figur 5, das nicht Teil der Erfindung ist, unterscheidet sich von dem der Figuren 3 und 4 dadurch, daß auf der der Montagefläche gegenüberliegenden Seite der Trägerplatte 7 eine weitere Platte 18 angeordnet ist. Die weitere Platte 18 besteht beispielsweise aus einem anderen Material wie die Trägerplatte 7. Bei geeigneter Wahl dieser Materialien, z. B. Glas für die Trägerplatte 7 und Silizium für die weitere Platte 18, können die Hochfrequenzeigenschaften des Wandlers verbessert und die Kapazität des optoelektronischen Wandlers gesenkt werden. Zudem kann durch unterschiedliche Brechungsindizes der weiteren Platte 18 und der Trägerplatte 7 die Aufbauhöhe und die optische Abbildung des opotelektronischen Wandlers optimiert werden.

Wie in Figur 5 dargestellt, weist hier nicht die Trägerplatte 7, sondern die weitere Platte 18 ein Mittel 21 zum Fokussieren der Strahlung, in diesem Fall eine sphärische oder eine asphärische Linse 28 auf.

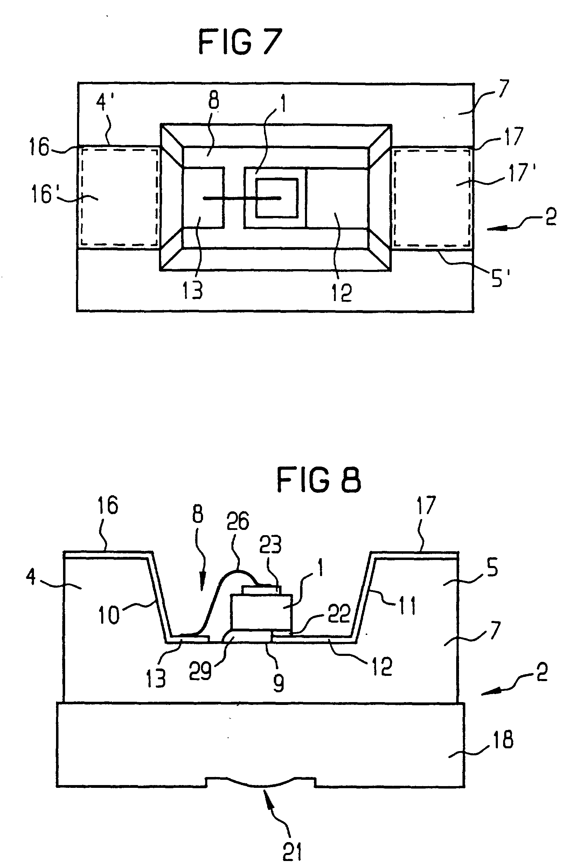

Das Ausführungsbeispiel gemäß Figuren 6 und 7 unterscheidet sich von dem in den Figuren 1 und 2 dargestellten Ausführungsbeispiel dadurch, daß die Ausnehmung 8 in der Trägerplatte 7 die Form einer von oben nach unten schmäler werdenden Grube aufweist, die beispielsweise mittels Ätzen hergestellt ist. Als Anschlußteile 4,5 sind hierbei Teilstücke der Seitenwand der Grube verwendet. Dies hat den Vorteil, daß die Anschlußflächen 16, 17 in beliegiger Anordnung auf der Oberseite der Seitenwand der Grube angeordnet werden können, wodurch beispielsweise die Gestaltung der Leiterbahnen auf einer dem optoelektronischen Wandler zugeordneten Leiterplatte weniger eingeschränkt ist.

Auf den Anschlußbahnen 12,13 können elektrisch leitende Anschlußteile 4',5' (z. B. sogenannte Silizium-Jumperchips) mit Anschlußflächen 16',17' befestigt sein, wobei die Anschlußflächen 16',17' beispielsweise in Form von Metallschichten realisiert sind.

Auf der der Grube gegenüberliegenden Seite der Trägerplatte 7 ist bei diesem Ausführungsbeispiel als Mittel 21 zur Fokussierung der Strahlung eine separat hergestellte sphärische oder asphärische Linse beispielsweise mittels Kleben aufgebracht. Anstelle der sphärischen oder asphärische Linse kann auch eine separat hergestellte Beugungsoptik aufgebracht oder in der Trägerplatte 7 ausgebildet sein. Letzteres gilt selbstverständlich auch für die sphärische oder asphärische Linse.

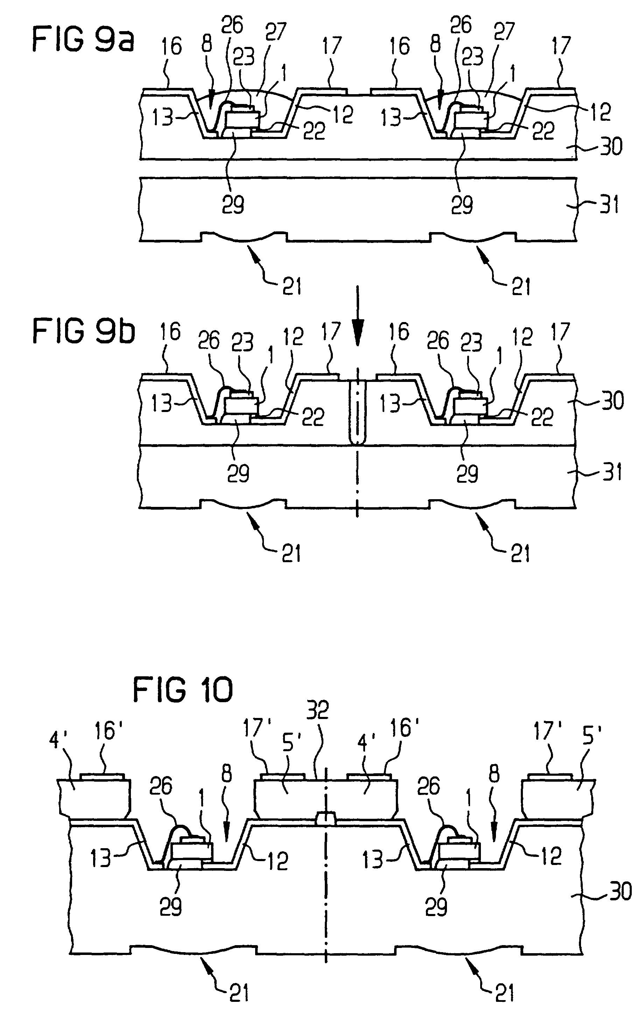

Bei dem Ausführungsbeispiel nach Figur 8 ist die Trägerplatte 7 im wesentlichen identisch zu der Trägerplatte von Figur 1 ausgebildet (man vergleiche die zugehörige Beschreibung). Ebenso kann die Trägerplatte analog zum Ausführungsbeispiel von Figur 6 und 7 ausgestaltet sein. Zusätzlich zu der Trägerplatte 7 weist die Trägereinheit 2 hier jedoch, eine weitere Platte 18 auf, in der ein Mittel 21 zur Fokussierung der Strahlung ausgebildet ist oder auch aufgebracht sein kann.

Anhand der in der Figur 9 gezeigten Darstellungen wird im folgenden der Verfahrensablauf für die gleichzeitige Herstellung einer Mehrzahl von optoelektronsichen Wandlern gemäß der Figur 8 erläutert:
- Zunächst werden in einer Trägerscheibe 30, die aus dem Material für die Trägerplatten 7 (hier beispielsweise Glas) besteht, beispielsweise mittels Ätzen oder Fräsen eine Mehrzahl von Ausnehmungen 8 hergestellt.
- Nachfolgend werden auf Teilbereichen der Oberfläche der Trägerscheibe 30 beispielsweise mittels Maskentechnik und Aufdampfen oder Sputtern eine Mehrzahl von Anschlußbahnen 12,13 aufgebracht.
- Als nächster Schritt wird in den Ausnehmungen 8 eine Mehrzahl von Körper 1 befestigt und deren Kontakte 22,23 mit den Anschlußbahnen 12,13 z. B. mittels eines elektrisch leitenden Lotes bzw. mittels Anschlußleiter 26 (Bonddrähte) elektrisch leitend verbunden.
- Falls erforderlich, werden dann die Zwischenräume zwischen den Strahlungsaustrittsflächen der Körper 1 und der Trägerscheibe 30 jeweils mit einem Koppelmedium 29 (z. B. Harz) gefüllt. Dies kann beispielsweise mittels eines Mikrodosiersystems erfolgen, mit dem das Koppelmedium direkt in den Zwischenraum eingespritzt wird.
- Anschließend können, falls vorgesehen, die Ausnehmungen 8 mit einem Gießharz oder mit einem Acrylat gefüllt werden, so daß die Körper 1 inclusive der Anschlußleiter 26 jeweils mit einer Chipabdeckung 27 versehen sind.
- Getrennt von der Herstellung der Trägerscheibe 30 mit den Körpern 1 kann eine Scheibe 31, die aus dem Material der Scheibe 18 von Figur 8, z. B. Silizium, besteht, mit einer Mehrzahl von Mitteln 21 zur Fokussierung der Stahlung versehen werden (Herstellungsverfahren wie oben bereits angegeben).
- Die Scheibe 31 wird dann mit der Trägerscheibe 30 beispielsweise mittels Löten, Kleben oder anodischem Bonden verbunden. Ebenso kann aber auch die Scheibe 31 schon vor der Montage der Körper 1 auf die Trägerscheibe 30 mit dieser verbunden werden. Der Scheibenverbund wird anschließend z. B. mittels Sägen vereinzelt.
- Vor der Vereinzelung des Scheibenverbundes können die optoelektronsichen Wandler elektrisch und optisch geprüft werden.

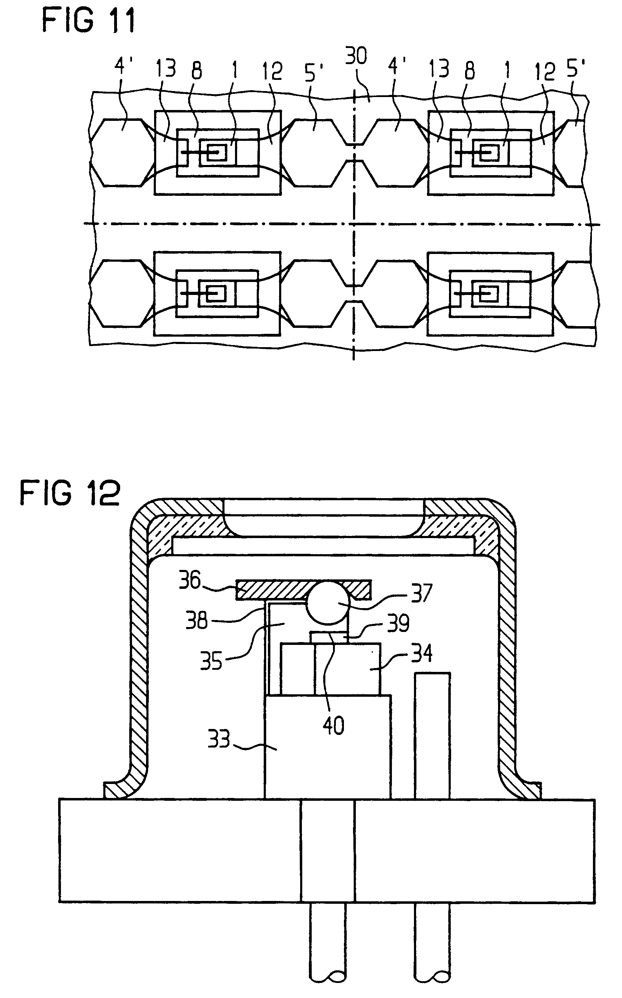

Bei dem im folgenden anhand der Figuren 10 und 11 erläuterten Verfahren zum Herstellen einer Mehrzahl von optoelektronsichen Wandlern gemäß denn Figuren 6 und 7 wird analog zum oben beschriebenen Verfahren eine Trägerscheibe 30 zunächst mit einer Mehrzahl von Ausnehmungen 8 versehen, auf die Oberseite der Trägerscheibe 30 eine Mehrzahl von Anschlußbahnen 12,13 aufgebracht und in den Ausnehmungen eine Mehrzahl von Körper 1 befestigt. Hinsichtlich Verbinden der elektrischen Kontakte der Körper 1 mit den Anschlußbahnen sowie hinsichtlich Koppelmedium und Chipabdeckung gilt ebenfalls dasselbe wie in Bezug auf Figur 9 angegeben.

Der Unterschied zu dem vorgenannten Verfahren besteht darin, daß erstens hier die Mittel 21 zum Fokussieren der Strahlung in der Trägerscheibe ausgebildet oder auf diese aufgebracht werden und daß zweitens auf die Anschlußbahnen paarweise miteinander verbundene elektrisch leitende Anschlußteile 4',5' (Anschlußteilpaare 32) mit Anschlußflächen 16',17' (beispielsweise Metallschichten) aufgebracht sind. Anschließend wird die Trägerscheibe 30 zusammen mit den Anschlußteilpaaren 32 ggf. nach elektrischer und/oder optischer Prüfung der Wandler in einzelne optoelektronische Wandler vereinzelt.

## Patentansprüche

1. Optoelektronischer Wandler mit mindestens einem Strahlung aussendenden und/oder empfangenden Körper (1), wobei der Wandler eine Trägerplatte (7) mit elektrischen Anschlussflächen (16,17 bzw. 16',17') aufweist, die an einer Oberseite der Trägerplatte (7) angeordnet sind, wobei
- die Trägerplatte (7) an der Oberseite eine Ausnehmung (8) mit einer Bodenfläche (9) und daran angrenzenden Seitenwänden aufweist,
- der Körper (1) auf der Bodenfläche (9) der Ausnehmung (8) befestigt ist,
- zumindest Teilbereiche der Ausnehmung (8) mit Anschlussbahnen (12, 13) zur elektrischen Verbindung zwischen den elektrischen Anschlussflächen (16,17 bzw. 16',17') und elektrischen Kontakten (22,23) des Körpers (1) versehen sind, und
- die Ausnehmung (8) derart ausgebildet ist, dass die maximale Höhe des Körpers (1) einschließlich sämtlicher Anschlussleiter (26) kleiner als der Abstand zwischen der Bodenfläche (9) und den elektrischen Anschlussflächen (16,17 bzw. 16',17') ist,
**dadurch gekennzeichnet, dass**
- der Körper (1) eine Strahlungsaustritts- und/oder - eintrittsfläche (6) aufweist, die zur Bodenfläche (9) der Ausnehmung (8) hin gerichtet ist, und
- die Trägerplatte (7) aus einem zumindest für einen Teil der von dem Körper (1) ausgesandten und/oder empfangenen Strahlung durchlässigen Material besteht,
- wobei die Anschlussbahnen (12, 13) zumindest teilweise außerhalb der Strahlungsaustritts- und/oder - eintrittsfläche des Körpers (1) angeordnet sind, und zwar derart, dass ein Strahlungsübergang zwischen dem Körper (1) und der Trägerplatte (7) oder umgekehrt ermöglicht wird.

2. Optoelektronischer Wandler nach Anspruch 1, **dadurch gekennzeichnet, dass** der Strahlung aussendende und/oder empfangende Körper (1) ein Halbleiterchip oder eine Polymer-Lumineszenz- oder -Laserdiode ist.

3. Optoelektronischer Wandler nach einem der vorangehenden Ansprüche, **dadurch gekennzeichnet, dass** die Trägerplatte (7) aus einem isolierenden Material besteht oder in den zur elektrischen Verbindung genutzten Teilbereichen der Seitenwände und im Bereich der elektrischen Anschlussflächen (16,17 bzw. 16',17') zumindest teilweise mit einer isolierenden Schicht (15) versehen ist

4. Optoelektronischer Wandler nach einem der vorangehenden Ansprüche, **dadurch gekennzeichnet, dass** auf den zur elektrischen Verbindung genutzten Seitenwänden der Ausnehmung (8) eine Anzahl von elektrisch leitenden Anschlussbahnen (12, 13) angeordnet sind die mit den elektrischen Kontakten (22, 23) des Körpers (1) in Verbindung stehen und auf der Oberseite der Trägerplatte (7) die elektrischen Anschlussflächen (16,17 bzw. 16',17') bilden.

5. Optoelektronischer Wandler nach einem der vorangehenden Ansprüche, **dadurch gekennzeichnet, dass** die Trägerplatte (7) an ihrer der Oberseite gegenüberliegenden Unterseite ein Mittel zum Fokussieren der Strahlung aufweist.

6. Optoelektronischer Wandler nach einem der Ansprüche 1 bis 5, **dadurch gekennzeichnet, dass** auf der der Oberseite gegenüberliegenden Unterseite der Trägerplatte (7) eine weitere Platte (18) vorgesehen ist, die einen anderen Brechungsindex aufweist als die Trägerplatte (7).

7. Optoelektronischer Wandler nach Anspruch 6, **dadurch gekennzeichnet, dass** die weitere Platte (18) ein Mittel (21) zum Fokussieren der Strahlung aufweist.

8. Optoelektronischer Wandler nach einem der Ansprüche 1 bis 7, **dadurch gekennzeichnet, dass** der Körper (1) mit einer Abdeckung (27) versehen ist.

9. Optoelektronischer Wandler nach einem der vorangehenden Ansprüche, **dadurch gekennzeichnet**, zwischen der Strahlungsaustritts- und/oder -eintrittsfläche (6) des Körpers (1) und der Bodenfläche (9) ein optisches Koppelmedium (29), insbesondere aus Gießharz, angeordnet ist.

10. Verfahren zum Herstellen eines optoelektronischen Wandlers, bei dem
- an einer Oberseite einer Trägerplatte (7) eine Ausnehmung (8) mit einer Bodenfläche (9) und daran angrenzenden Seitenwänden hergestellt wird,auf Teilbereichen der Ausnehmung (8) und auf der Oberseite der Trägerplatte (7) elektrische Anschlussbahnen (12, 13) aufgebracht werden, die auf der Oberseite der Trägerplatte (7) elektrische Anschlussflächen (16, 17) bilden,
- auf der Bodenfläche (9) der Ausnehmung (8) mindestens ein Strahlung aussendender und/oder empfangender Körper (1) befestigt wird,
- die elektrischen Anschlussbahnen (12, 13) mit elektrischen Kontakten (22, 23) des Körpers (1) elektrisch leitend verbunden werden,
- wobei die Ausnehmung (8) derart bemessen wird, dass die maximale Höhe des Körpers (1) einschließlich sämtlicher Anschlussleiter (26) kleiner als der Abstand zwischen der Bodenfläche (9) und den elektrischen Anschlussflächen (16,17 bzw. 16',17') ist, und
- wobei der Körper (1) derart an der Bodenfläche (9) befestigt wird, dass seine Strahlungsaustritts- und/oder - eintrittsfläche (6) zur Bodenfläche (9) der Ausnehmung (8) hin gerichtet ist,
- wobei die Trägerplatte (7) aus einem zumindest für einen Teil der von dem Körper (1) ausgesandten und/oder empfangenen Strahlung durchlässigen Material besteht und
- wobei die Anschlussbahnen (12, 13) zumindest teilweise außerhalb der Strahlungsaustritts- und/oder - eintrittsfläche des Körpers (1) derart angeordnet werden, dass ein Strahlungsübergang zwischen dem Körper (1) und der Trägerplatte (7) oder umgekehrt ermöglicht wird.

## Claims

1. Optoelectronic transducer having at least one radiation-emitting and/or -receiving body (1), the transducer having a carrier plate (7) with electrical terminal areas (16, 17 or 16', 17') which are arranged on a top side of the carrier plate (7),
- the carrier plate (7) having, on the top side, a recess (8) with a bottom area (9) and side walls adjoining the latter,
- the body (1) being fastened on the bottom area (9) of the recess (8),
- at least partial regions of the recess (8) being provided with terminal tracks (12, 13) for electrical connection between the electrical terminal areas (16, 17 or 16', 17') and electrical contacts (22, 23) of the body (1), and
- the recess (8) being designed in such a way that the maximum height of the body (1) including all the connecting conductors (26) is smaller than the distance between the bottom area (9) and the electrical terminal areas (16, 17 or 16', 17'),
**characterized in that**
- the body (1) has a radiation exit and/or entry face (6) which is directed towards the bottom area (9) of the recess (8), and
- the carrier plate (7) is composed of a material which is transparent at least to part of the radiation which is emitted and/or received by the body (1),
- the terminal tracks (12, 13) being at least partially arranged outside the radiation exit and/or entry face of the body (1), to be precise in such a way as to enable a radiation transition between the body (1) and the carrier,plate (7) or vice versa.

2. Optoelectronic transducer according to Claim 1, **characterized in that** the radiation-emitting and/or -receiving body (1) is a semiconductor chip or a polymer light-emitting or laser diode.

3. Optoelectronic transducer according to one of the preceding claims, **characterized in that** the carrier plate (7) is composed of an insulating material or is at least partially provided with an insulating layer (15) in the partial regions of the side walls that are utilized for electrical connection and in the region of the electrical terminal areas (16, 17 or 16', 17').

4. Optoelectronic transducer according to one of the preceding claims, **characterized in that** a number of electrically conductive terminal tracks (12, 13) are arranged on the side walls of the recess (8) that are utilized for electrical connection, which terminal tracks are connected to the electrical contacts (22, 23) of the body (1) and form the electrical terminal areas (16, 17 or 16', 17') on the top side of the carrier plate (7).

5. Optoelectronic transducer according to one of the preceding claims, **characterized in that** the carrier plate (7) has a means for focusing the radiation on its underside opposite to the top side.

6. Optoelectronic transducer according to one of Claims 1 to 5, **characterized in that** a further plate (18) is provided on the underside of the carrier plate (7) opposite to the top side, which further plate has a different refractive index from the carrier plate (7).

7. Optoelectronic transducer according to Claim 6, **characterized in that** the further plate (18) has a means (21) for focusing the radiation.

8. Optoelectronic transducer according to one of Claims 1 to 7, **characterized in that** the body (1) is provided with a covering (27).

9. Optoelectronic transducer according to one of the preceding claims, **characterized in that** an optical coupling medium (29), in particular made of casting resin, is arranged between the radiation exit and/or entry face (6) of the body (1) and the bottom area (9).

10. Method for the production of an optoelectronic transducer, in which
- a recess (8) with a bottom area (9) and side walls adjoining the latter is produced on a top side of a carrier plate (7), and electrical terminal tracks (12, 13) are applied on partial regions of the recess (8) and on the top side of the carrier plate (7), which terminal tracks form electrical terminal areas (16, 17) on the top side of the carrier plate (7),
- at least one radiation-emitting and/or -receiving body (1) is fastened on the bottom area (9) of the recess (8),
- the electrical terminal tracks (12, 13) are electrically conductively connected to electrical contacts (22, 23) of the body (1),
- the recess (8) being dimensioned in such a way that the maximum height of the body (1) including all the connecting conductors (26) is smaller than the distance between the bottom area (9) and the electrical terminal areas (16, 17 or 16', 17'), and
- the body (1) being fastened on the bottom area (9) in such a way that its radiation exit and/or entry face (6) is directed towards the bottom area (9) of the recess (8),
- the carrier plate (7) being composed of a material which is transparent at least to part of the radiation which is emitted and/or received by the body (1), and
- the terminal tracks (12, 13) being at least partially arranged outside the radiation exit and/or entry face of the body (1) in such a way as to enable a radiation transition between the body (1) and the carrier plate (7) or vice versa.

## Revendications

1. Convertisseur optoélectronique comprenant au moins un corps (1) émettant du rayonnement et/ou en recevant, le convertisseur comportant une plaque (7) support ayant des surfaces (16, 17 et 16', 17') de connexion électrique qui sont disposées sur un côté supérieur de la plaque (7) support, dans lequel
- la plaque (7) support a, du côté supérieur, un évidement (8) ayant une surface (9) de fond et des parois latérales qui en sont adjacentes ;
- le corps (1 ) est fixé sur la surface (9) de fond de l'évidement (8) ;
- au moins des zones partielles de l'évidement (8) sont munies de pistes (12, 13) de connexion pour la liaison électrique entre les surfaces (16, 17 et 16', 17') de connexion électrique et des contacts (22, 23) électriques du corps (1 ) ; et
- l'évidement (8) est tel que la hauteur maximum du corps (1), y compris l'ensemble des conducteurs (26) de connexion, est plus petite que la distance entre la surface (9) de fond et les surfaces (16, 17 et 16', 17') de connexion électrique,
**caractérisé en ce que**
- le corps (1) a une surface (6) de sortie du rayonnement et/ou d'entrée du rayonnement, qui est dirigée vers la surface (9) de fond de l'évidement (8) ; et
- la plaque (7) support est en un matériau transparent, au moins pour une partie, du rayonnement émis et/ou reçu par le corps (1) ;
- les pistes (12, 13) de connexion étant disposées, au moins en partie, à l'extérieur de la surface de sortie et/ou d'entrée du rayonnement du corps (1) et cela de sorte qu'un passage du rayonnement soit possible entre le corps (1 ) et la plaque (7) support ou inversement.

2. Convertisseur optoélectronique suivant la revendication 1, **caractérisé en ce que** le corps (1) émettant du rayonnement et/ou en recevant est une puce à semi-conducteur ou une diode à polymère luminescent ou une diode laser.

3. Convertisseur optoélectronique suivant l'une des revendications précédentes, **caractérisé en ce que** la plaque (7) support est en un matériau isolant ou est munie, dans les zones partielles utilisées pour la liaison électrique des parois latérales et dans la zone des surfaces (16, 17 et 16', 17') de connexion électrique, au moins en partie, d'une couche (15) isolante.

4. Convertisseur optoélectronique suivant l'une des revendications précédentes, **caractérisé en ce que** sur les parois latérales, utilisées pour la liaison électrique, de l'évidement (8), sont disposées un certain nombre de pistes (12, 13) de connexion conductrices de l'électricité, qui sont en liaison avec les contacts (22, 23) électriques du corps (1) et qui forment sur le côté supérieur de la plaque (7) support les surfaces (16, 17 ou 16', 17') de connexion électrique.

5. Convertisseur optoélectronique suivant l'une des revendications précédentes, **caractérisé en ce que** la plaque (7) support a, sur son côté inférieur opposé à son côté supérieur, un moyen de focalisation du rayonnement.

6. Convertisseur optoélectronique suivant l'une des revendications 1 à 5, **caractérisé en ce qu'**il est prévu, sur le côté inférieur opposé au côté supérieur de la plaque (7) support, une autre plaque (18) qui a un indice de réfraction autre que celui de la plaque (7) support.

7. Convertisseur optoélectronique suivant la revendication 6, **caractérisé en ce que** l'autre plaque (18) comporte un moyen (21) de focalisation du rayonnement.

8. Convertisseur optoélectronique suivant l'une des revendications 1 à 7, **caractérisé en ce que** le corps (1) est muni d'un couvercle (27).

9. Convertisseur optoélectronique suivant l'une des revendications précédentes, **caractérisé en ce qu'**il est interposé, entre la surface (6) de sortie et/ou d'entrée du rayonnement du corps (1) et la surface (9) de fond, un milieu (29) de couplage optique, notamment en résine de coulée.

10. Procédé de fabrication d'un convertisseur optoélectronique, dans lequel
- on produit, sur un côté supérieur d'une plaque (7) support, un évidement (8) ayant une surface (9) de fond et des parois latérales qui en sont adjacentes, on dépose sur des zones partielles de l'évidement (8) et sur le côté supérieur de la plaque (7) support des pistes (12, 13) de connexion électrique qui forment sur le côté supérieur de la plaque (7) support des surfaces (16, 17) de connexion électrique ;
- on fixe sur la surface (9) de fond de l'évidement (8) au moins un corps (1 ) émettant du rayonnement et/ou en recevant ;
- on relie d'une manière conductrice de l'électricité les pistes (12, 13) de connexion électrique à des contacts (22, 23) électriques du corps (1) ;
- l'évidement (8) étant tel que la hauteur maximum du corps (1), y compris l'ensemble des conducteurs (26) de connexion, est plus petite que la distance entre la surface (9) de fond et les surfaces (16, 17 et 16', 17') de connexion électrique ; et
- le corps (1 ) étant fixé à la surface (9) de fond de façon à ce que sa surface (10) de sortie et/ou d'entrée du rayonnement soit dirigée vers la surface (9) de fond de l'évidement (8) ;
- la plaque (7) support est en un matériau transparent au moins pour une partie du rayonnement émis et/ou reçu par le corps (1) ; et
- les pistes (12, 13) de connexion étant disposées, au moins en partie, à l'extérieur de la surface de sortie et/ou d'entrée du rayonnement du corps (1) et cela de sorte qu'un passage du rayonnement soit possible entre le corps (1) et la plaque (7) support ou inversement.
